# EUROPEAN PATENT APPLICATION

(11) **EP 0 895 444 A1**
(43) Date of publication of application: **03.02.1999**
(21) Application number: 98306002.1
(22) Date of filing: 28.07.1998
(51) Int. Cl.: H05K 1/02, H05K 7/20

(54) **Circuit assembly**

(30) Priority: 01.08.1997 GB 9716222
(71) Applicant: LUCAS INDUSTRIES public limited company, London W1Y 4DJ (GB)
(72) Inventor: Strickley, David William, Hall Green, Birmingham, B28 (GB)
(74) Representative: Carpenter, David

(57) **Abstract**

A circuit assembly comprises a circuit board (11) and a heat plate (12) affixed thereto. The heat plate (12) comprises a metal substrate (17) which has a layer of an electrically insulating material (18) secured to the face of the metal substrate (17) remote from the circuit board (11). The insulating layer (18) isolates the metal substrate (17) from the wire legs (14) of devices (16) placed upon the board (11).

## Description

This invention relates to a circuit board of the kind including a metal plate for dissipating heat generated by components carried by the circuit board.

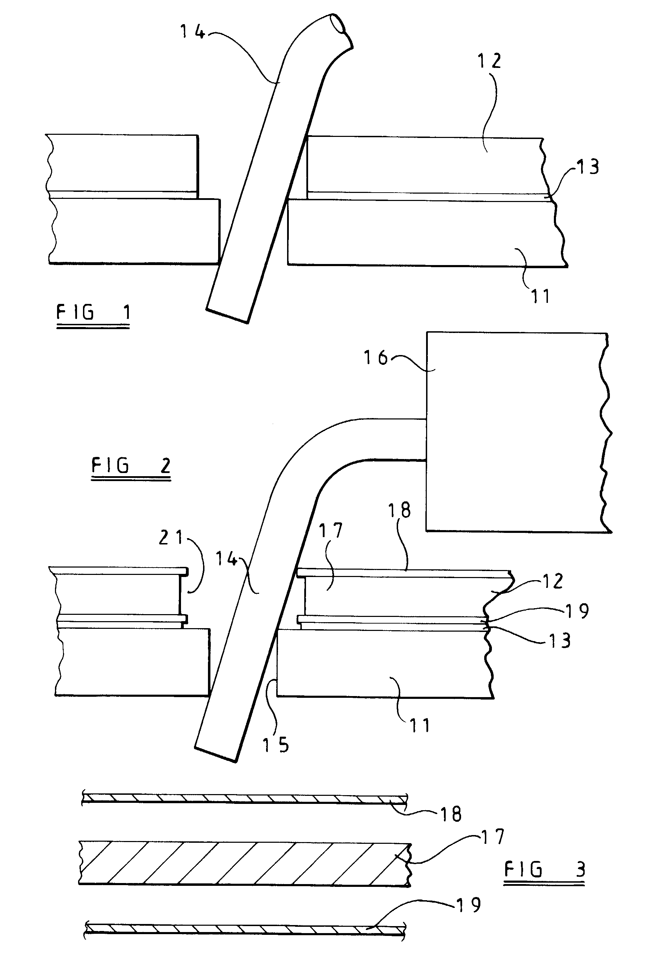

The use of metal heat plates is most prevalent in relation to printed circuit boards where the heat plate is arranged to effect a more even distribution and/or dissipation of heat, generated by components on the board, by way of radiation or conduction to a casing or housing of the printed circuit board assembly. It is common, as shown in Figure 1 of the accompanying drawings, to mount a heat plate 12 on a printed circuit board 11 by means of a layer of an electrically insulating adhesive 13. As is usual, the board 11 comprises an electrically insulating substrate carrying an electrical conductor pattern on its upper and/or lower surface with electrical connections being made to the conductor pattern inter alia by wire legs 14 of devices carried by the board. The heat plate 12 is conventionally a plate formed from aluminium, or another metal of good thermal conductivity, and in order to provide access to the board 11 for the legs 14, it is necessary to provide apertures in the plates 12. Figure 1 illustrates a recognised disadvantage of such conventional arrangements in that the leg 14 in extending through an aperture in the plate 12 may touch an edge of the plate and thus make electrical connection thereto perhaps resulting in a short to ground.

It has been proposed in the case of aluminium heat plates to provide an insulating surface layer on the plate by anodization but it is recognised that at the edge of a plate 12 the anodized layer is fragile, and susceptible to damage.

It is an object of the present invention to provide a circuit board assembly wherein the aforementioned disadvantage is minimised.

In accordance with the present invention there is provided a circuit board assembly comprising a circuit board and a heat plate affixed thereto, characterised in that the heat plate comprises a metal substrate having a self-supporting layer of an electrically insulating material secured to the face of the metal substrate remote from the circuit board.

Preferably the heat plate has a second self-supporting layer of electrically insulating material bonded to its face presented to the circuit board.

Preferably edge regions of the heat plate have their metal substrate undercut beneath the or each insulating layer.

Preferably the or each electrically insulating layer is a layer of an organic electrically insulating material.

Desirably said organic insulating material is a reinforced synthetic resin material.

Conveniently said material is reinforced by glass fibres.

In the accompanying drawings:-
Figure 1 is a diagrammatic cross-sectional view of a prior art circuit board assembly;
Figure 2 is a view similar to Figure 1 illustrating an assembly in accordance with a first example of the present invention;
Figures 3, 4, 5 and 6 illustrate four stages in the manufacture of a heat plate used in the assembly of Figure 2; and
Figure 7 is a view similar to Figure 2 illustrating a further circuit board assembly.

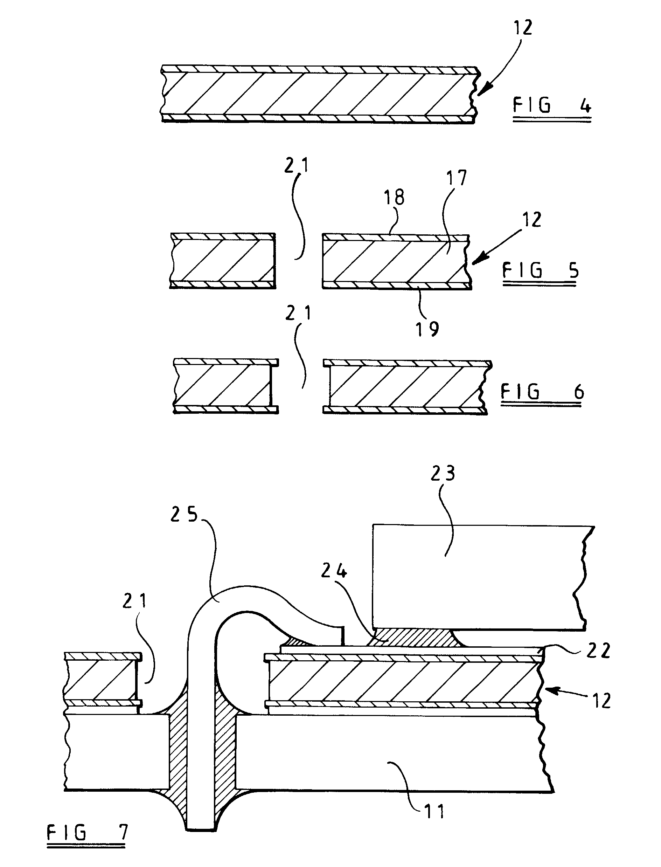

Referring first to Figures 2 to 6 of the accompanying drawings, the circuit board assembly includes a printed circuit board 11 of conventional form comprising an electrically insulating substrate carrying a pattern of conductors on the upper and/or lower surface thereof. Drillings 15 may be provided in the circuit board 11 to accommodate connecting legs 14 of devices 16 carried by the board 11 and in some cases the drillings 15 may be plated to provide for a soldered connection to the respective legs 14, and where appropriate to provide electrical interconnection between conductive tracks on upper and lower surfaces of the board 11.

Secured to one surface of the board 11, conventionally the upper surface in use, is a heat plate 12 comprising a planar aluminium substrate 17 clad on its upper and lower faces respectively with self-supporting layers 18, 19 of electrically insulating material.

The layers 18, 19 can be handled as individual sheets of material and are adhesively bonded to the upper and lower surfaces respectively of the aluminium substrate 17 using an adhesive which can withstand the physical conditions imposed upon the printed circuit board in use, both in terms of temperature fluctuations and vibrations. However it should be recognised that the layers 18, 19 could be self-adhesive insulating layers such as cured glass fibre reinforced resin layers which are engaged with the substrate 17 before curing and which bond with the substrate 17 upon curing. Although the nature of the layers 18, 19 is not critical it is to be understood that they must be electrically insulating layers, and must be sufficiently strong to withstand contact by legs 14 of devices 16 as will be described in more detail hereinafter. Desirably therefore the material of the layers 18, 19 will be an organic insulating material, preferably a fibre reinforced synthetic resin material, epoxy resin/glass fibre and polyimide/glass fibre combinations being suitable.

Where a leg 14 or other connector is to pass adjacent an edge of the heat plate 12, whether that edge is defined at the periphery of the plate, or at the boundary of a drilling through the plate, or at the edge of a slot cut in the plate, then it will be understood that the corner defined between the edge surface of the plate and the face of the plate remote from the board 11 will be a corner of the upper layer 18, and thus will be insulating material. It follows therefore that simply by utilizing an upper layer 18 on the substrate 17 of the plate 12 the risk of inadvertent electrical connection between a leg 14 and the substrate 17 of the plate 12 is minimized. However, there can be situations in which the leg 14 passes adjacent the corner defined between the edge and the lower surface of the plate 12, and thus it is extremely desirable to provide the layer 19 cladding the lower surface.

The risk of inadvertent electrical connection between a leg 14 and the aluminium substrate 17 of the plate 12 can be further reduced by ensuring that in use the edge surfaces of the substrate 17 are undercut in relation to the edge of the or each layer 18, 19. Such an arrangement is illustrated in Figure 2, and also in Figure 6. The plate 12 will thus be manufactured using, for example, the following sequence. A layer 18, and desirably also a layer 19 will be adhesively bonded to respective faces of an aluminium plate constituting the substrate 17 of the heat plate 12. Using N/C machining the plate 12 will then be drilled and where appropriate routed to produce a passage or cut-out 21 in the plate 12 to accommodate, in use, a leg 14 or other device connection. Thereafter the machined plate is subjected to a chemical de-burr/etching operation which removes any metallic burrs of the substrate 17 resulting from the machining, and at the same time etches the exposed edges of the metallic substrate 17 so that immediately prior to bonding or otherwise affixing the plate 12 to the circuit board 11 all of the edges of the substrate 17 are undercut with respect to the insulating layer or layers 18, 19. The undercutting thus applies to any exposed edges of the substrate 17 whether at the periphery of the plate 12, or at the boundary of drillings or cut-outs within the body of the plate 12. Naturally if desired exposed areas of the substrate 17 could be masked so as to be unaffected by the etching process. This could be the case if, for example, the machining was designed to cut away areas of one or both insulating layers 18, 19 to leave an exposed area of the substrate 17 for direct thermal contact with a device of the circuit board.

The protruding regions of the insulating layers are strong enough to withstand contact by a leg 14 or the like, and wear arising due to a leg vibrating against the layer in use. Moreover the edge surfaces of the substrate 17 can be coated if desired to minimise environmental attack thereon in use.

It will be recognised that the heat plate 12 is intended to distribute and/or dissipate heat generated by electrical components carried by the circuit board 11, so as to avoid localised overheating of the board and its devices. Thus there may be situations in which it is desirable for a device to make direct contact with the metal of the plate 12, and indeed there may be occasions where the metal of the plate 12 makes direct contact with the casing of the device utilizing the circuit board to facilitate heat transfer to the case. In these regions it may be necessary to expose the substrate 17 by cutting away the surface layers 18, 19. Alternatively the insulating material layers 18, 19 may be pre-shaped prior to the bonding stage to produce windows where the substrate 17 can make direct contact with the casing of the device, this being particularly the case when using layers which bond to the substrate during curing, since they exhibit very little movement during curing and thus the registration of the precut apertures with the corresponding regions of the plate 12 is not lost during curing.

Desirably the plate 12 will be adhesively secured to the upper surface of the board 11.

Figure 7 illustrates an arrangement in which the insulating layer 18 of the heat plate 12 carries conductive elements 22 upon which circuit components or devices 23 are directly mounted through solder contact pads 24 or the like. Connecting wires 25 or other connection devices are soldered to the tracks of the board 11 and extend through apertures 21 in the plate 12 to make connection to the conductors 22.

It will be recognised that although aluminium and its alloys are extremely convenient materials for the manufacture of the substrate 17 of the plate 12, other metals can be used where appropriate, for example copper, molybdenum and copper invar alloys may be used in appropriate applications.

In the absence of the insulating layers 18, 19 on the aluminium substrate 17 a very high degree of accuracy would be needed in positioning of apertures within the plate 12, and the positioning of the plate 12 on the board 11. To achieve such a high degree of accuracy in drilling or other machining of the plate 12 it would be extremely desirable, if not essential, to machine the aluminium while in a "half-hard" condition. However, while machining "half-hard" aluminium is desirable from the point of view of accuracy, the use of aluminium in this condition as a heat plate on a circuit board 11 is undesirable as the optimum minimization of stress imposed on the circuit board 11 by the plate 12 occurs when the aluminium is in a fully annealed condition. However, any attempt to anneal the aluminium plate after it is machined will result in distortion and dimensional movement of the metal of the plate due to changes in its grain structure, and there would be consequential loss of tolerance and thus loss of the necessary accuracy when the plate 12 is secured to the board 11. A benefit of the present invention, where the substrate 17 of the plate 12 carries one or more insulating layers is that the required accuracy of machining of the substrate 17 can be of a lower order by virtue of the reduced risk (arising from the presence of the layer 18) of inadvertent electrical connection between the substrate 17 and a leg 14 and so fully annealed aluminium can be used for the substrate 17. Any loss of accuracy is not crucial given the presence of the insulating layer 18, and preferably also the layer 19, to minimise the risk of inadvertent electrical connections with a leg 14 or the like. Moreover, where the substrate 17 is clad with the insulating layers 18, 19 there appears to be little or no loss of accuracy when machining fully annealed aluminium (by comparison with "half hard" aluminium) and so given the good aperture definition which can be produced, even greater accuracy can be achieved in the finished product.

## Claims

1. A circuit board assembly comprising a circuit board (11) and a heat plate (12) affixed thereto, characterised in that the heat plate (12) comprises a metal substrate (17) having a self-supporting layer (18) of an electrically insulating material secured to the face of the metal substrate (17) remote from the circuit board (11).

2. A circuit board assembly as claimed in Claim 1, characterised in that said heat plate (12) has a second self-supporting layer (19) of an electrically insulating material bonded to its face presented to the circuit board (11).

3. A circuit board assembly as claimed in either Claim 1 or Claim 2, characterised in that the, or each, insulating layer (18, 19) is provided as a single sheet.

4. A circuit board assembly as claimed in any of the preceding claims characterised in that the edge regions of the heat plate (12) have their metal substrate (17) undercut beneath the, or each, insulating layer (18, 19).

5. A circuit board assembly as claimed in any of the preceding claims characterised in that the, or each, electrically insulating layer (18, 19) is of an organic electrically insulating material.

6. A circuit board assembly as claimed in Claim 5, characterised in that said organic electrically insulating material is a reinforced synthetic resin material.

7. A circuit board assembly as claimed in Claim 6, characterised in that said reinforced synthetic resin material is reinforced by glass fibres.

8. A circuit board assembly as claimed in any of Claims 1 to 3, characterised in that there is provided at least one aperture in the, or each, insulating layer (18, 19) such that electrical contact is formed between the metal substrate (17) and a casing.

9. A circuit board assembly as claimed in any of Claims 1 to 3, characterised in that the, or each, insulating layer (18, 19) forms an adhesive bond with said metal substrate (17).
